# FASCICULE DE BREVET EUROPEEN

(11) **EP 3 027 994 B1**
(45) Date de publication et mention de la délivrance du brevet: **07.06.2017**
(21) Numéro de dépôt: 14747608.9
(22) Date de dépôt: 31.07.2014
(51) Int. Cl.: F28D 15/02, F28D 15/04, H01L 23/427

(54) **EVAPORATEUR À ASSEMBLAGE SIMPLIFIÉ POUR BOUCLE DIPHASIQUE**
VERDAMPFER MIT VEREINFACHTER MONTAGE FÜR ZWEIPHASIGER KREISLAUF
EVAPORATOR WITH SIMPLIFIED ASSEMBLY FOR DIPHASIC LOOP

(30) Priorité: 01.08.2013 FR 1357678
(43) Date de publication de la demande: 08.06.2016
(73) Titulaire: Calyos SA, 6040 Jumet (BE)
(72) Inventeur: DE TROZ, Vincent, B-1400 Nivelles (BE)
(74) Mandataire: Cabinet Plasseraud
(86) Numéro de dépôt international: PCT/EP2014/066473
(87) Numéro de publication internationale: WO 2015/014929

(56) Documents cités:
- DE-U1-202009 005 595
- US-A- 5 998 863
- US-A1- 2003 051 859
- US-A1- 2007 006 992

## Description

La présente invention est relative aux évaporateurs pour systèmes de transfert thermique diphasiques à pompage capillaire correspondant au préambule de la revendication 1. Un tel évaporateur est connu, par exemple, de la figure 3A du document DE 20 2009 005 595 U1. Plus particulièrement, l'invention concerne la constitution et l'assemblage de tels évaporateurs, en particuliers ceux destinés à évacuer les calories produites généralement par un élément dissipatif, en particulier mais non exclusivement par un processeur électronique ou un dispositif de commutations électroniques quelconque.

Le développement des échanges de données par le réseau internet a entrainé un besoin énorme de puissance de calcul et de stockage dans les serveurs permettant de répondre aux besoins des utilisateurs et en particulier ces serveurs sont souvent regroupés dans des centres appelés 'data centers'.

Les besoins de refroidissement des cartes électroniques formant les serveurs dans ces 'data centers' ne cessent de croître en raison de la densité toujours plus élevée des processeurs dans ces cartes.

Il est connu d'utiliser une circulation d'air ou d'un fluide liquide pour refroidir le processeur d'une carte serveur. La circulation d'un tel fluide requiert l'utilisation d'un ou plusieurs ventilateurs ou d'une ou plusieurs pompes qui peuvent être sujets à des pannes ou tout du moins requiert une maintenance régulière.

Il est donc préférable d'utiliser un système passif c'est-à-dire dépourvu de pompe active pour extraire les calories du processeur, ce type de système utilisant un phénomène de pompage capillaire. Un tel système est décrit dans le document US2003/051859 ; cependant la fonction condenseur fait encore appel à un ventilateur et de plus l'évaporateur placé au dessus de chaque processeur est complexe à fabriquer et par conséquent couteux. En outre l'encombrement et la fiabilité de fonctionnement d'un tel évaporateur peut être améliorés.

Il est donc apparu un besoin de réduire le coût de tels évaporateurs sans remettre en cause leurs performances, afin de pouvoir proposer des systèmes de transfert thermique diphasique à pompage capillaire pour diverses applications à gros volumes de fabrication.

A cet effet, l'invention propose notamment un évaporateur pour système de transfert thermique diphasique à pompage capillaire, comprenant :
- une plaque de base avec un bord périphérique et une face externe de réception thermique destinée à recevoir des calories depuis un élément dissipatif, la face externe s'étendant généralement selon un plan P d'interface adjacent à l'élément dissipatif,
- un corps avec un fond, des portions latérales et une bordure adjacente au bord périphérique de la plaque de base pour délimiter ainsi un espace intérieur de l'évaporateur,
- une masse poreuse formant une couche à structure capillaire, interposée entre la plaque de base et le fond, qui définit une première chambre délimitée par la plaque de base, les portions latérales et ladite masse poreuse et une deuxième chambre délimitée par le fond, les portions latérales et ladite masse poreuse,
la première chambre étant destinée à héberger du fluide caloporteur en phase essentiellement gazeuse, et comprend une sortie d'évaporateur pour une conduite tubulaire de gaz, la deuxième chambre étant destinée à héberger du fluide caloporteur en phase essentiellement liquide, et comprend une entrée d'évaporateur pour une conduite tubulaire de liquide, caractérisé en ce que le corps est assemblé sur la plaque de base par une opération de sertissage au cours de laquelle on forme, par fluage de matériau, un joint hermétique entre la plaque de base et le corps.

Ainsi, on évite de faire appel à une opération de collage, vissage, rivetage ou soudage pour obtenir un assemblage étanche de l'évaporateur.

Grâce à ces dispositions, on obtient un évaporateur particulièrement simple à assembler et donc particulièrement peu couteux. On obtient ainsi un assemblage à process maîtrisé, potentiellement automatisé et bien répétable et on peut donc envisager de les produire en grande série à un coût très attractif.

Dans des modes de réalisation du procédé selon l'invention, on peut éventuellement avoir recours en outre à l'une et/ou à l'autre des dispositions suivantes :
- on dispose avantageusement une projection de jointure issue intégralement du corps et faisant saillie vers la plaque de base, pénétrant dans la masse poreuse, de sorte que l'on assure une étanchéité capillaire entre les première et deuxième chambres. En d'autres termes, l'étanchéité capillaire évite que la vapeur ne court-circuite le poreux et ne pénètre dans la deuxième chambre ce qui est préjudiciable à la performance du système. Ainsi on obtient par une même opération de sertissage l'étanchéité d'une chambre par rapport à l'autre et l'étanchéité globale de l'évaporateur par rapport au milieu extérieur ;
- la projection de jointure peut être formée par une lèvre présentant une section avec une extrémité pointue dirigée vers la plaque de base ; moyennant quoi, la pénétration de la lèvre de jointure dans la masse poreuse est facilitée et la profondeur de pénétration confère ainsi une bonne étanchéité entre la première chambre et la deuxième chambre ;
- la face externe de la plaque de base peut être sensiblement plane, et peut être configurée pour être pressée contre un processeur de carte électronique formant l'élément dissipatif ; de sorte que cet évaporateur est particulièrement bien adapté pour les systèmes de refroidissement des cartes électroniques et en particulier le refroidissement des processeurs ou CPU qui y sont implantés ;
- l'évaporateur peut présenter une épaisseur E selon une direction perpendiculaire au plan P inférieure à 35mm ; de sorte qu'un tel évaporateur peut facilement être intégré sur des processeurs de carte serveur de format « 1U » c'est-à-dire d'épaisseur de l'ordre de 45 mm ;
- l'entrée et la sortie d'évaporateur sont agencées parallèlement au plan P dans l'une des parois latérales. De sorte que l'encombrement perpendiculairement au plan P n'est pas augmenté par l'entrée, la sortie et les conduites de fluide ;
- la plaque de base peut comprendre des projections faisant saillie vers l'intérieur, ces projections formant les canaux de récupération de vapeur et formant entretoise de maintien de la masse poreuse ; de sorte qu'il est possible d'utiliser une couche poreuse toute simple sans usinage, les canaux de vapeur étant issus des formes de la plaque de base ;
- la masse poreuse peut former une couche d'épaisseur constante parallèle au plan d'interface P ; de sorte qu'on peut utiliser un élément poreux très bon marché, simplement découpé à la bonne longueur et bonne largeur, sans autre préparation ;
- la plaque de base présente une forme rectangulaire et le corps présente une forme rectangulaire avec quatre cotés formant les portions latérales ; de sorte que la plaque de base peut être parfaitement adaptée à la géométrie d'un processeur ou CPU sur lequel elle est installée, et le corps est une pièce de géométrie simple à fabriquer ;
- la plaque de base est en cuivre, et le corps est en acier inox ; moyennant quoi, la plaque de base présente un très bon coefficient de transfert thermique et une ductilité adéquate pour l'opération de sertissage ; en outre, le corps présente des caractéristiques de durabilité et de compatibilité aux fluides adéquates ;
- le corps comprend des ailettes agencées sur la face externe du fond du corps ; de sorte que si des bulles de gaz viennent se former dans la deuxième chambre liquide, elles sont re-condensées par l'effet refroidissant des ailettes ;
- le corps comprend des moyens de fixation à la carte électronique, par exemple sous forme d'extensions latérales parallèles au plan P, de préférence percées de trous ; On améliore ainsi la capacité d'intégration de l'évaporateur sur une carte électronique et on diminue le coût global de la fonction refroidissement ;
- la bordure du corps comprend une rainure dans laquelle vient se loger, pendant le sertissage, de la matière issue de la déformation du bord périphérique de la plaque de base ; moyennant quoi on optimise les formes complémentaires de la plaque de base et du corps pour obtenir un sertissage de qualité assurant l'étanchéité de l'espace interne de l'évaporateur.

L'invention vise également un procédé pour assembler un évaporateur tel que celui du type décrit ci-dessus, le procédé comprenant les étapes :
**a**- fournir une plaque de base,
**b-** fournir un couvercle,
**c-** déposer une couche de matériau poreux au-dessus de la plaque de base
**d-** sertir le couvercle sur la plaque de base pour former par fluage de matériau un joint hermétique entre la plaque de base et le corps.

Avantageusement, on forme simultanément une étanchéité capillaire entre les deux chambres par pénétration de la projection de jointure dans la masse poreuse.

Finalement, l'invention vise aussi un système de transfert thermique diphasique à pompage capillaire, comprenant un évaporateur tel que celui du type décrit ci-dessus.

D'autres caractéristiques et avantages de l'invention apparaîtront au cours de la description suivante d'une de ses formes de réalisation, donnée à titre d'exemple non limitatif, en regard des dessins joints.

Sur les dessins :
- la figure 1 est une vue générale schématique d'un système de refroidissement à boucle diphasique intégrant un évaporateur selon l'invention,
- la figure 2 est une vue générale en perspective d'un dispositif de refroidissement intégrant un évaporateur selon l'invention,
- la figure 3 est une vue en coupe transversale d'un évaporateur selon l'invention,
- la figure 4 montre une vue de dessous du corps de l'évaporateur de la figure 3,
- les figures 5 et 6 illustrent le procédé d'obtention de l'évaporateur par sertissage, et
- la figure 7 représente une variante de réalisation concernant les bordures de la plaque de base et du corps.

Sur les différentes figures, les mêmes références désignent des éléments identiques ou similaires.

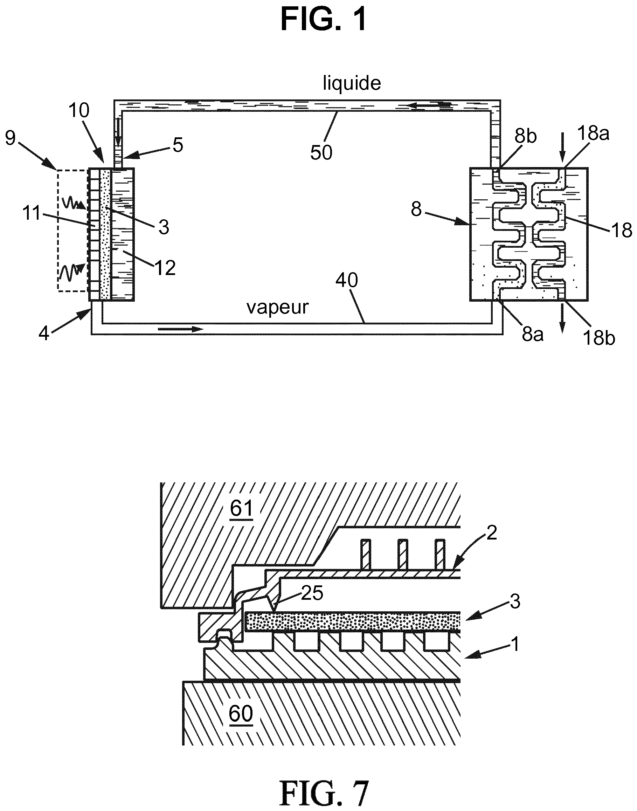

La figure 1 représente un exemple de dispositif de de refroidissement à boucle diphasique à circuit fermé, qui comprend un évaporateur **10,** un module condenseur **8,** une première conduite fluide **40** dite 'vapeur' reliant la sortie de l'évaporateur à l'entrée du module condenseur, et une deuxième conduite fluide **50** dite 'liquide' reliant la sortie du module condenseur à l'entrée de l'évaporateur.

La circulation d'un fluide de travail diphasique est assurée par l'intermédiaire de l'effet de capillarité prévalant dans une masse poreuse **3** agencée à l'intérieur de l'évaporateur **10.** Ladite masse poreuse 3 sépare une première chambre **11** en contact thermique avec la source chaude et destinée à contenir généralement du fluide de travail en phase gazeuse, d'une seconde chambre **12** agencées à l'opposé de la source chaude dans l'évaporateur et destiné à contenir du fluide de travail principalement en phase liquide.

Comme il est connu en soi, l'énergie thermique apportée au niveau de l'évaporateur transforme du liquide en vapeur ce qui permet d'absorber une énergie équivalente à la chaleur latente de vaporisation du fluide de travail. La vapeur ainsi créée est dirigée sous pression dans la première conduite **40** vers l'entrée **8a** du module condenseur. À cet endroit, le fluide de travail cède ses calories soit directement dans l'environnement, soit à un autre fluide **18** liquide en conduite forcée (comme cela est représenté, entrée **18a,** sortie **18b**), et par le fait le fluide de travail repasse en phase liquide après avoir cédé une énergie correspondant à la chaleur latente.

Le fluide liquide à la sortie **8b** du condenseur est aspiré par l'effet de pompage procuré par la structure capillaire de la masse poreuse, la deuxième chambre et la conduite **50** étant remplies du fluide de travail en phase liquide.

De tels systèmes à pompage capillaire sont connus sous les acronymes de LHP ('Loop Heat Pipe') ou CPL ('Capillary Pumped Loop') et sont utilisés tant dans un environnement sans gravité (espace) que dans des applications terrestres avec gravité.

Il faut remarquer que la figure 1 ne mentionne pas la direction verticale et par conséquent il n'y a pas de contrainte particulière concernant l'orientation et la position respective de l'évaporateur et du module condenseur pour autant que l'effet de pompage capillaire reste supérieur aux effets de la gravité compte tenu de la densité du fluide utilisé.

Selon la présente invention, on vise principalement les systèmes terrestres avec des applications à fort volume ou grande série, c'est-à-dire des nombres très important de pièces à fabriquer. Dans ce contexte, on cherche à diminuer le coût de revient et le coût de production des composants du système et en particulier de l'évaporateur capillaire 10.

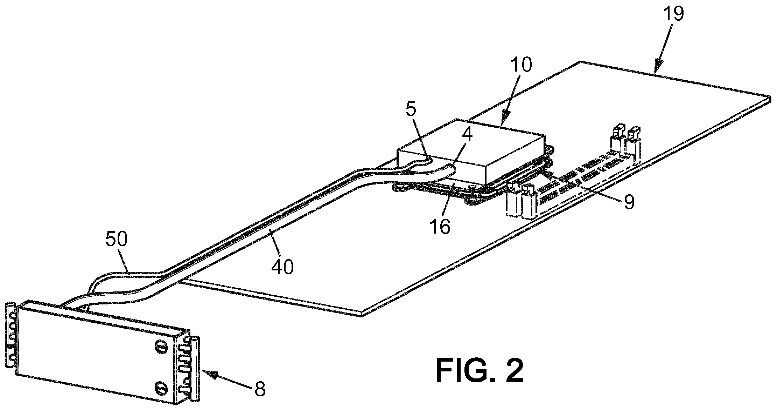

Une des applications visées par la présente invention concerne (non exclusivement) le refroidissement des cartes électroniques et notamment des processeurs ou CPU qui sont implantés sur des cartes électroniques dans des ordinateurs, des serveurs classiques ou bien encore des racks de cartes serveur. Sur la figure 2, il est représenté schématiquement une carte électronique **19** munie d'au moins un processeur **9.** Dans la configuration illustrée, la carte est représentée en position horizontale, mais elle pourrait tout aussi bien être en position verticale.

Au-dessus du processeur **9** est disposé un évaporateur capillaire **10** selon l'invention configuré pour prélever des calories dissipées par le processeur 9 selon un processus de boucle capillaire diphasique déjà décrit plus haut.

Le module condenseur **8** est formé par un échangeur de chaleur de type liquide/liquide de préférence à flux croisés, connus en soi et donc non décrit en détails ici. Le fluide refroidisseur **18** sera typiquement de l'eau, à la température où elle est disponible dans le bâtiment, ou voisine de la température ambiante ou encore légèrement refroidie.

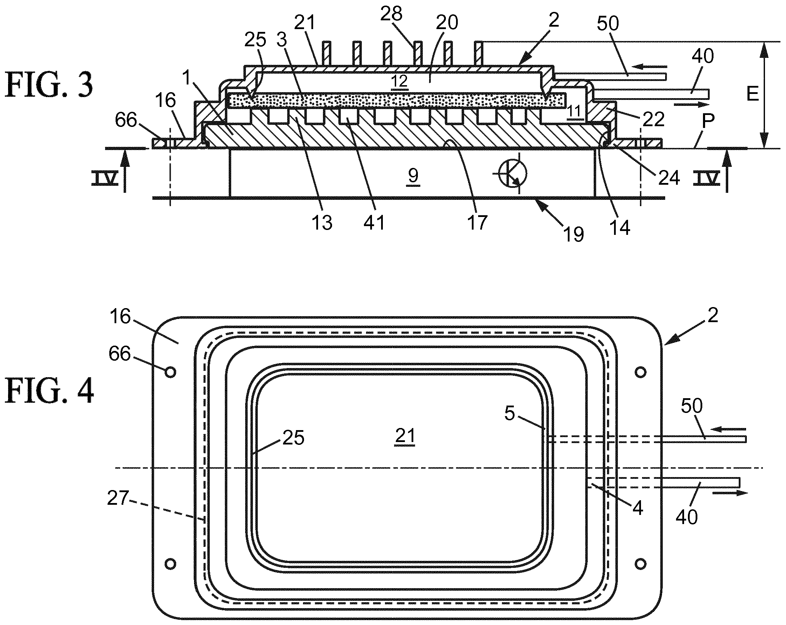

Comme représenté à la figure 3, l'évaporateur comprend une plaque de base **1** destinée à venir en contact physique et thermique avec le processeur 9 selon un plan d'interface **P** et un corps **2** qui complémente la plaque de base pour former une enceinte aussi appelé un espace interne **20,** dans lequel sont agencés les éléments de l'évaporateur qui seront décrits ci-après.

La plaque de base 1 comprend un bord périphérique **14** et une face externe **17** de réception thermique destinée à recevoir des calories depuis un élément dissipatif tel que le processeur 9 en question. Du côté opposé à la face externe, c'est-à-dire du côté dit interne, sont agencés une pluralité de projections **13** sous forme de nervures s'étendant continûment ou de façon discontinue et de préférence parallèlement les unes aux autres, de manière à créer entre ces rainures des canaux **41** destinés à convoyer la vapeur formée à cet endroit vers la sortie de vapeur **4.** Les projections pourraient aussi être des pions arrangés en matrice ou en quinconce et séparés les uns des autres. La plaque de base est formée de préférence en cuivre, matériau qui présente un très bon coefficient de conduction thermique et qui en outre présente une très bonne ductilité dont l'intérêt sera vu plus loin.

Au-dessus des projections 13 se trouvent une couche à structure capillaire formant une masse poreuse **3,** qui dans l'exemple illustré se présente comme une couche d'épaisseur constante sans aucune forme secondaire particulière. Ainsi il suffit de découper une couche poreuse aux bonnes dimensions de largeur et longueur, il n'y a pas besoin d'usiner des canaux de vapeur à l'intérieur de cette masse poreuse.

La constitution et le procédé d'obtention d'une telle masse poreuse **3** est connu en soi et ne sont donc pas décrits en détails ici.

Le corps **2** susmentionné de l'évaporateur est agencé au-dessus de la plaque de base et de la masse poreuse, ce corps est réalisé de préférence en acier inoxydable dit 'inox'. Ce corps 2 comprend un fond 21, qui forme une paroi parallèle au plan P, des parois latérales 22 qui s'étendent à partir du fond tout autour de l'évaporateur en direction d'une bordure **24** qui borde le corps 2 au voisinage du plan d'interface P.

La bordure **24** et le bord périphérique **14** de la plaque de base sont joints de façon hermétique comme il sera détaillé ci-après.

De cette façon, une première chambre **11** dite gazeuse est formée dans l'évaporateur et délimitée par la plaque de base les portions latérales **22** et la masse poreuse **3.** Une seconde chambre **12** dite liquide est formée dans l'évaporateur est délimitée par le fond **21** du corps, les portions latérales 22 et la masse poreuse 3.

La séparation hermétique entre les première et deuxième chambres est réalisée par une projection de jointure **25** issue intégralement du corps, cette projection de jointure fait saillie vers la plaque de base et pénètre dans la masse poreuse pour former à cet endroit une barrière étanche pour le fluide de travail.

On forme ainsi une étanchéité capillaire entre la chambre liquide **12** et la chambre vapeur **11,** c'est-à-dire plus précisément il n'y a pas d'autres passages possibles entre les deux chambres que de passer par l'épaisseur de la masse poreuse **3.** En particulier, on évite ainsi tout risque de passage de liquide chaud vaporisé (vapeur) vers la chambre liquide ce qui aurait pour effet indésirable d'augmenter sa température et qu'il serait nécessaire de re-condenser cette vapeur sous forme liquide en la refroidissant. La fermeture étanche formée par la projection de jointure **25** venant pénétrer dans la masse poreuse empêche tout passage direct entre la chambre vapeur et la chambre liquide.

Une mauvaise étanchéité capillaire entraine un risque de fuite de la chambre vapeur **11** vers la chambre liquide **12 ;** une telle fuite aurait pour effet de dégrader les performances thermiques (réduction de la densité de flux maximale et de la puissance maximale transférable). Plus précisément, dans l'exemple illustré ici, la projection de jointure se présente comme une lèvre à bord aigu, c'est-à-dire la lèvre présente une section généralement triangulaire avec une extrémité pointue.

En outre, le corps **2** comprend des extensions latérales **16** obtenues de forme intégralement par le formage du corps 2, ces extensions latérales s'étendent de préférence parallèlement au plan P et sont munies de trous 66. De manière connue en soi, des vis à ressort (non représentées) permettent de presser l'évaporateur contre le processeur.

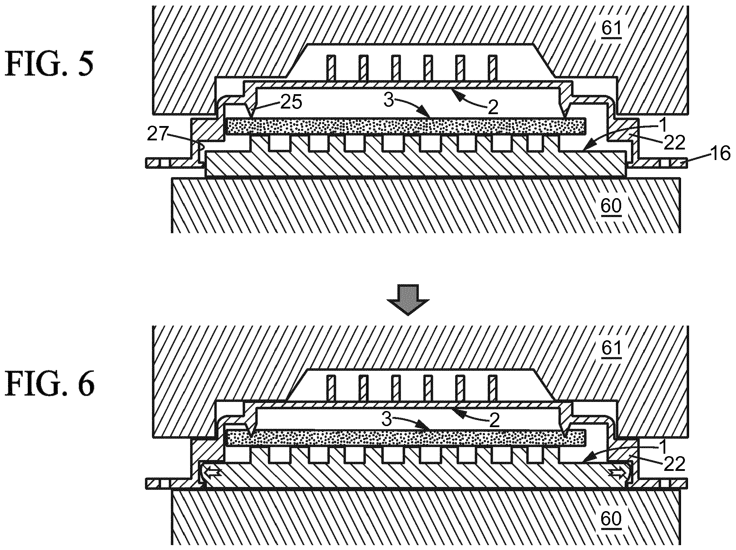

Optionnellement, le fond 21 du corps peut présenter sur sa face externe une pluralité d'ailettes **28** qui ont pour fonction de limiter l'échauffement du liquide dans la deuxième chambre **12** et qui permettent aussi de re-condenser des bulles de gaz qui auraient pu se former près de la masse poreuse et qui remontent vers le fond **21.**
comme illustré aux figures 5 et 6, en vue de d'assembler l'évaporateur 10, on dispose une plaque de base 1 sur une embase **60** de presse, puis on dispose une couche de masse poreuse **3** sur la plaque de base (le cas échéant sur les projections **13** ménagées dans la plaque de base comme vu plus haut) puis on dispose le corps **2** au-dessus de la plaque de base et de la masse poreuse, la bordure **24** du corps entourant avec un jeu très réduit le bord périphérique **14** de la plaque de base. L'extrémité de la lèvre de jointure porte sur la masse poreuse.

Ensuite, on dispose un poinçon **61** de presse au-dessus du corps **2** puis une pression est appliquée vers le bas sur le poinçon **61** en vue de sertir le corps sur la plaque de base.

Pendant le déplacement du poinçon, il se produit d'une part une déformation ductile du bord périphérique de la plaque de base (en cuivre de préférence) et simultanément la pénétration de l'extrémité de la lèvre de jointure **25** dans la masse poreuse **3.**

Sous la pression exercée par le poinçon, le bord périphérique **14** de la plaque de base vient fluer dans une rainure **27** prévue à cet effet au niveau de la bordure 24 du corps **2,** ce qui permet d'obtenir une complémentarité de formes assurant l'étanchéité.

Grâce à l'agence et décrit plus haut, on obtient un évaporateur capillaire assemblé d'épaisseur faible ; dans l'exemple illustré, l'épaisseur **E** de l'évaporateur est inférieure à 35mm, voire 30mm, ce qui permet une intégration facile sur des cartes serveur disposées les unes au-dessus des autres dans des racks.

Comme illustrée à la figure 7, la bordure **24** du corps **2** et le bord périphérique **14** de la plaque de base peuvent prendre des formes différentes en particulier, la rainure dans le peut être ouverte vers le bas et la zone de jonction entre les deux pièces peut se trouver à distance du plan **P.**

Avantageusement, l'épaisseur E de l'évaporateur **10** selon une direction perpendiculaire au plan **P** est inférieure à 35mm, voire inférieure à 30mm, ce qui permet d'utiliser cet évaporateur dans des endroits très confinés et ce qui facilitent son intégration dans divers environnements ; en particulier cette solution et avantages de pour le refroidissement des cartes électroniques.

À cet égard, il faut remarquer que les sorties **5,4** des conduites de liquide **50** et gazeuse **40** sont agencées parallèlement au plan **P** ce qui n'augmente pas l'épaisseur totale de l'évaporateur **10.**

Il faut bien noter que la boucle capillaire à fluide diphasique forme un système passif, qui ne requiert pas d'entretien, qui ne génère pas de bruit de ventilateur ou pompe.

Il faut aussi noter qu'une graisse de contact thermique peut être interposée entre la plaque de base et le processeur.

Il faut noter qu'en vue d'améliorer les performances en étanchéité de la fermeture du corps **2** sur de la plaque de base **1,** il peut être avantageux d'ajouter un cordon de colle (non représenté) dans les coins arrondis de la rainure **27** ménagée dans le corps.

Pour améliorer la fiabilité du démarrage de la boucle diphasique, il peut être prévu un dispositif anti retour au voisinage du débouché de l'entrée liquide 5, ce dispositif anti retour empêchant du liquide de refluer vers le condenseur par la conduite liquide **50.**

Bien sûr, l'évaporateur capillaire serti décrit ci-dessus peut être utilisé pour évacuer les calories de tout élément du dispositif, pas seulement d'un processeur électronique.

## Revendications

1. Evaporateur (10) pour système de transfert thermique diphasique à pompage capillaire, comprenant :
- une plaque de base 1 avec un bord périphérique (14) et une face externe de réception thermique destinée à recevoir des calories depuis un élément dissipatif (9), la face externe s'étendant généralement selon un plan P d'interface adjacent à l'élément dissipatif,
- un corps (2) avec un fond (21), des portions latérales (22) et une bordure (24) adjacente au bord périphérique (14) de la plaque de base pour délimiter ainsi un espace intérieur (20) de l'évaporateur,
- une masse poreuse (3) formant une couche à structure capillaire, interposée entre la plaque de base et le fond, qui définit une première chambre (11) délimitée par la plaque de base, les portions latérales et ladite masse poreuse et une deuxième chambre (12) délimitée par le fond, les portions latérales et ladite masse poreuse,
la première chambre étant destinée à héberger du fluide caloporteur en phase essentiellement gazeuse, et comprend une sortie d'évaporateur (4) pour une conduite tubulaire de gaz, la deuxième chambre étant destinée à héberger du fluide caloporteur en phase essentiellement liquide, et comprend une entrée d'évaporateur (5) pour une conduite tubulaire de liquide, **caractérisé en ce que** le corps est assemblé sur la plaque de base par une opération de sertissage au cours de laquelle on forme, par fluage de matériau, un joint hermétique entre la plaque de base et le corps,de sorte que l'on évite de faire appel à une opération de collage, vissage, rivetage ou soudage pour obtenir un assemblage étanche de l'évaporateur.

2. Evaporateur selon la revendication 1, comprenant une projection de jointure (25) issue intégralement du corps et faisant saillie vers la plaque de base, pénétrant dans la masse poreuse pendant le sertissage, de sorte que l'on assure une étanchéité capillaire entre les première et deuxième chambres (11,12).

3. Evaporateur selon la revendication 2, dans lequel la projection de jointure (25) est formée par une lèvre présentant une section avec une extrémité pointue dirigée vers la plaque de base.

4. Evaporateur selon l'une des revendications 1 à 3, dans lequel la face externe est sensiblement plane, et est configurée pour être pressée contre un processeur de carte électronique formant l'élément dissipatif.

5. Evaporateur selon la revendication 4, dans lequel l'évaporateur présente une épaisseur (E) selon une direction perpendiculaire au plan P inférieure à 35mm.

6. Evaporateur selon l'une des revendications 1 à 5, dans lequel l'entrée et la sortie d'évaporateur sont agencées parallèlement au plan P dans l'une des parois latérales.

7. Evaporateur selon l'une des revendications 1 à 6, dans lequel la plaque de base comprend des projections 13 faisant saillie vers l'intérieur, ces projections formant les canaux de récupération de vapeur et entretoise de maintien de la masse poreuse.

8. Evaporateur selon l'une des revendications 1 à 7, dans lequel la masse poreuse 3 forme une couche d'épaisseur constante parallèle au plan d'interface P.

9. Evaporateur selon l'une des revendications 1 à 8, dans lequel la plaque de base présente une forme rectangulaire et le corps présente une forme rectangulaire avec quatre cotés formant les portions latérales.

10. Evaporateur selon l'une des revendications 1 à 9, dans lequel la plaque de base est en cuivre, et le corps est en acier inox.

11. Evaporateur selon l'une des revendications 1 à 10, dans lequel le corps comprend des ailettes (28) agencées sur la face externe du fond du corps.

12. Evaporateur selon l'une des revendications 1 à 5, dans lequel le corps comprend des moyens de fixation à la carte électronique, par exemple sous forme d'extensions latérales parallèle au plan P, de préférence percées de trous.

13. Evaporateur selon l'une des revendications 1 à 12, dans lequel la bordure (24) du corps comprend une rainure (27) dans laquelle vient se loger, pendant le sertissage, de la matière issue de la déformation du bord périphérique (14) de la plaque de base.

14. **Procédé** pour assembler un évaporateur selon l'une des revendications 1-12,
le procédé comprenant les étapes :
**a-** fournir une plaque de base,
**b-** fournir un couvercle,
**c-** déposer une couche de matériau poreux au dessus de la plaque de base
**d-** sertir le couvercle sur la plaque de base pour former par fluage de matériau un joint hermétique entre la plaque de base et le corps.

15. **Procédé** selon la revendication 14, dans lequel à l'étape d-, on forme simultanément une étanchéité capillaire entre les deux chambres par pénétration de la projection de jointure (25) dans la masse poreuse.

16. Système de transfert thermique diphasique à pompage capillaire, comprenant un évaporateur selon l'une des revendications 1 à 13.

## Patentansprüche

1. Verdampfer (10) für ein zweiphasiges Kapillarpumpenwärmeübertragungssystem, welcher aufweist:
- eine Basisplatte (1) mit einem umlaufenden Rand (14) und einer Außenfläche zur Wärmeaufnahme, welche dazu bestimmt ist, Energie von einem dissipativen Element (9) aufzunehmen, wobei sich die Außenfläche im Wesentlichen entsprechend einer Grenzflächenebene (P) benachbart zum dissipativen Element erstreckt,
- einen Körper (2) mit einem Boden (21), Seitenteilen (22) und einem Rahmen (24), welcher benachbart zum umlaufenden Rand (14) der Basisplatte ist, um so einen Innenraum (20) des Verdampfers abzugrenzen,
- eine poröse Masse (3), welche eine zwischen der Basisplatte und dem Boden liegende Schicht mit kapillarer Struktur bildet und welche eine erste Kammer (11), welche von der Basisplatte, den Seitenteilen und der porösen Masse begrenzt ist, und eine zweite Kammer (12) definiert, welche von dem Boden, den Seitenteilen und der porösen Masse begrenzt ist,
wobei die erste Kammer dazu bestimmt ist, das Wärmeübertragungsfluid aufzunehmen, welches sich in einer im Wesentlichen gasförmigen Phase befindet, und einen Verdampferauslass (4) für eine rohrförmige Gasleitung aufweist, und wobei die zweite Kammer dazu bestimmt ist, das Wärmeübertragungsfluid aufzunehmen, welches sich in einer im Wesentlichen flüssigen Phase befindet, und einen Verdampfereinlass (5) für eine rohrförmige Flüssigkeitsleitung aufweist,
**dadurch gekennzeichnet,**
**dass** der Körper auf der Basisplatte durch einen Crimpvorgang montiert ist, mit dem durch Materialkriechen eine hermetische Dichtung zwischen der Basisplatte und dem Körper gebildet ist, so dass ein Hinzuziehen eines Klebe-, Schraub-, Niet- oder Schweißvorgangs zum Erreichen einer dichten Montage des Verdampfers erspart bleibt.

2. Verdampfer nach Anspruch 1,
welcher einen Verbindungsgrat (25) aufweist, der in einstückiger Weise aus dem Körper hervorgeht und einen Überstand in Richtung der Basisplatte bildet, wobei der Verbindungsgrat (25) in die poröse Masse während des Crimpens eindringt, so dass eine kapillare Abdichtung zwischen der ersten und der zweiten Kammer (11, 12) sichergestellt ist.

3. Verdampfer nach Anspruch 2,
bei dem der Verbindungsgrat (25) durch eine Lippe gebildet ist, welche einen Abschnitt mit einem spitzen Ende darstellt, das gegen die Basisplatte gerichtet ist.

4. Verdampfer nach einem der Ansprüche 1 bis 3,
bei dem die Außenfläche im Wesentlichen eben ist und derart ausgebildet ist, gegen einen Prozessor einer elektronischen Platine pressbar zu sein, welcher das dissipative Element bildet.

5. Verdampfer nach Anspruch 4,
bei dem der Verdampfer in einer Richtung senkrecht zur Ebene (P) eine Dicke (E) von weniger als 35 mm hat.

6. Verdampfer nach einem der Ansprüche 1 bis 5,
bei dem der Einlass und der Auslass des Verdampfers parallel zur Ebene (P) an einer der Seitenwände angeordnet sind.

7. Verdampfer nach einem der Ansprüche 1 bis 6,
bei dem die Basisplatte Überstände (13) aufweist, die nach innen hervorstehen, wobei diese Überstände Gasrückführungskanäle und Abstandshalter zum Halten der porösen Masse bilden.

8. Verdampfer nach einem der Ansprüche 1 bis 7,
bei dem die poröse Masse (3) eine Schicht mit konstanter Dicke parallel zur Grenzflächenebene (P) bildet.

9. Verdampfer nach einem der Ansprüche 1 bis 8,
bei dem die Basisplatte eine rechteckige Form hat und der Körper eine rechteckige Form mit vier Seiten hat, welche die Seitenteile bilden.

10. Verdampfer nach einem der Ansprüche 1 bis 9,
bei dem die Basisplatte aus Kupfer ist und der Körper aus Edelstahl ist.

11. Verdampfer nach einem der Ansprüche 1 bis 10,
bei dem der Körper Rippen (28) aufweist, welche auf der Außenfläche des Bodens von dem Körper angeordnet sind.

12. Verdampfer nach einem der Ansprüche 1 bis 5,
bei dem der Körper Mittel zur Befestigung auf der elektronischen Platine aufweist, zum Beispiel in Form von seitlichen Ausdehnungen parallel zur Ebene (P), vorzugsweise durchgehende Löcher.

13. Verdampfer nach einem der Ansprüche 1 bis 12,
bei dem der Rahmen (24) des Körpers eine Aussparung (27) aufweist, in die während des Crimpens als Ergebnis der Verformung des umlaufenden Rands (14) Material der Basisplatte eingreift.

14. Verfahren zum Montieren eines Verdampfers nach einem der Ansprüche 1 bis 12,
wobei das Verfahren die Schritte aufweist:
a- Bereitstellen einer Basisplatte,
b- Bereitstellen einer Abdeckung,
c- Ablegen einer Schicht von einem porösen Material auf der Basisplatte,
d- Crimpen der Abdeckung auf die Basisplatte, um mittels Materialkriechen eine hermetische Dichtung zwischen der Basisplatte und dem Körper zu bilden.

15. Verfahren Anspruch 14,
bei dem im Schritt d- gleichzeitig eine kapillare Abdichtung zwischen den zwei Kammern durch Eindringen des Verbindungsgrats (25) in die poröse Masse gebildet wird.

16. Zweiphasiges Kapillarpumpenwärmeübertragungssystem, welches einen Verdampfer nach einem der Ansprüche 1 bis 13 aufweist.

## Claims

1. Evaporator (10) for a two-phase thermal transfer system with capillary pumping, comprising:
- a base plate (1) with a peripheral edge (14) and an outer surface for thermal reception intended to receive heat from a dissipative element (9), where the outer surface generally extends along an interface plane P adjacent to the dissipative element,
- a body (2) with a back (21), lateral portions (22) and a border (24) adjacent to the peripheral edge (14) of the base plate in order to delimit an inner space (20) for the evaporator in that way,
- a porous mass (3) forming a capillary structure layer, interposed between the base plate and the back, which defines a first chamber (11) delimited by the base plate, the lateral portions and said porous mass and a second chamber (12) delimited by the back, the lateral portions and said porous mass,
where the first chamber is intended to house the working fluid in essentially gaseous phase, and includes an evaporator outlet (4) for a tubular gas conduit, where the second chamber is intended to house the working fluid in essentially liquid phase, and includes an evaporator inlet (5) for a tubular liquid conduit,
**characterized in that** the body is assembled on the base plate by a crimping operation during which, a hermetic seal between the base plate and the body is formed by material flowing/creeping, in such a way that it is avoided a bonding, screwing, riveting or welding operation to obtain a sealed assembly of the evaporator.

2. Evaporator according to claim 1, comprising a joint projection (25) integrally formed with the body and projecting towards the base plate, which penetrates into the porous mass such that a capillary seal is provided between the first and second chambers (11, 12).

3. Evaporator according to claim 2, wherein the joint projection (25) is formed by a lip having a section with a pointed end directed towards the base plate.

4. Evaporator according to any one of claims 1 to 3, wherein the outer surface is substantially flat and is configured in order to press against a processor on an electronic board forming the dissipative element.

5. Evaporator according to claim 4, wherein the evaporator has a thickness (E) along a direction perpendicular to the plane P less than 35 mm.

6. Evaporator according to any one of claims 1 to 5, wherein the evaporator inlet and outlet are arranged parallel to the plane P in one of the lateral walls.

7. Evaporator according to any one of claims 1 to 6, wherein the base plate includes projections (13) projecting inward, where these projections form vapor recovery channels and form spacers for holding the porous mass.

8. Evaporator according to any one of claims 1 to 7, wherein the porous mass (3) forms a layer of constant thickness parallel to the interface plane P.

9. Evaporator according to any one of claims 1 to 8, wherein the base plate has a rectangular shape and the body has a rectangular shape with four sides forming the lateral portions.

10. Evaporator according to any one of claims 1 to 9, wherein the base plate is copper and the body is stainless steel.

11. Evaporator according to any one of claims 1 to 10, wherein the body includes fins (28) arranged on the outer surface of the back of the body.

12. Evaporator according to any one of claims 1 to 5, wherein the body includes means for attachment to the electronic card, for example in the form of lateral extensions parallel to the plane P, preferably screw holes.

13. Evaporator according to any one of claims 1 to 12, wherein the border (24) for the body includes a groove (27) in which the material coming from ductile deformation of the peripheral edge (14) of the base plate comes to be lodged during crimping.

14. Process for assembly of an evaporator according to any one of claims 1-12,
the process comprising the steps:
**a-** providing a base plate;
**b-** providing a cover;
**c-** placing a porous material on top of the base plate;
**d-** crimping the cover onto the base plate in order to form by material flowing/creeeping a hermetic seal between the base plate and the body.

15. process according to claim 14, wherein in step d- a capillary seal is simultaneously formed between the two chambers by penetration of the joint projection (25) into the porous mass.

16. Two-phase thermal transfer system with capillary pumping comprising an evaporator according to any one of claims 1 to 13.
